# EUROPÄISCHE PATENTANMELDUNG

(11) **EP 3 239 665 A1**
(43) Veröffentlichungstag der Anmeldung: **01.11.2017**
(21) Anmeldenummer: 17167007.8
(22) Anmeldetag: 19.04.2017
(51) Int. Cl.: G01D 11/24, G01D 11/30

(54) **SENSORGEHÄUSE**

(30) Priorität: 25.04.2016 DE 102016107575; 25.04.2016 DE 202016102166 U
(71) Anmelder: Weickmann & Weickmann PartmbB, 81635 München (DE)
(72) Erfinder: Steinich, Klaus Manfred, 85604 Zorneding / Pöring (DE)

(57) **Zusammenfassung**

Um ein Gehäuse (3) für einen darin aufgenommenen Sensor möglichst verformungsstabil auszugestalten, wird es einerseits einstückig aus Metall statt aus Kunststoff hergestellt und darüber hinaus die Durchgangsöffnungen (6a, b) für das Befestigen des Sensors mittels Verschrauben an einem anderen Bauteil so positioniert und dimensioniert, dass die dadurch aufbringbaren Kräfte nicht in der Lage sind, das eine definierte Stabilität aufweisende Gehäuse (3) zu verformen.

## Beschreibung

### I. Anwendungsgebiet

Die Erfindung betrifft einen Sensor, der in einem vorzugsweise flachen, wannenförmigen Gehäuse untergebracht ist, beispielsweise einen Winkelsensor oder Neigungssensor.

### II. Technischer Hintergrund

Bei derartigen Sensoren besteht das eigentliche Sensorelement aus einem Mikrochip, der auf einer Elektronikplatine untergebracht ist, die auch den Rest der Auswerteschaltung des Sensors trägt.

Derartige Sensoren verfügen meist über zwei oder drei VerschraubungsÖffnungen, mittels der sie mit hindurch gesteckten Schrauben an einem Bauteil der Umgebung befestigt werden, dessen Neigen, Drehen oder Verschwenken gemessen werden soll.

Aus Kostengründen ist bei einem solchen Sensor häufig die Elektronikplatine in einem wannenförmigen Gehäuse aus Kunststoff angeordnet und meist darin dicht mittels einer zumindest teilweise aushärtenden Vergussmasse vergossen.

Das wannenförmige Gehäuse aus Kunststoff besitzt in aller Regel eine ebene Bodenseite und eine parallel dazu verlaufende, offene Oberseite, von der aus die Elektronikplatine in die Vertiefung des wannenförmigen Gehäuses eingelegt und dort vergossen wird. Diese offene Oberseite kann auch noch zusätzlich durch einen darauf aufgelegten und verklebten oder verschraubten Deckel verschlossen sein.

Das Problem besteht darin, dass solche Sensoren mit einer ihrer ebenen Seiten auf einer Fläche verschraubt werden, die nicht vollständig eben ist, beispielsweise leicht ballig ist oder kleine, vorstehende Erhebungen aufweist. Dies führt dazu, dass beim Verschrauben und Festziehen der Befestigungsschrauben Druck auf die Befestigungsaugen des Sensorgehäuses in einer solchen Richtung ausgeübt wird, dass es zu einem leichten Verziehen des Sensorgehäuses kommen kann, da das Gehäuse - auch mit dem anschließenden Verguss - nicht so stabil ist, dass durch die bei der Verschraubung gegebenenfalls aufgebrachten Kräfte keine Verformung folgt.

Dies gilt für ein Gehäuse aus Kunststoff fast immer, und hängt selbst bei einem Gehäuse aus Metall, wie etwa Aluminium, von dessen Dimensionierung ab. Natürlich kann man Höhe und Wandstärke eines solchen Aluminium-Gehäuses so wählen, dass durch die Befestigungs-Kräfte keine Verformung eintritt, jedoch besteht eine Forderung bei solchen Sensoren auch darin" dass sie zusätzlich möglichst klein und auch leicht ausgebildet sein sollen

Verformt sich das wannenförmige Gehäuse, so überträgt sich dies von dort auf die zumindest teilweise ausgehärtete Vergussmasse und dort wiederum auf die Elektronikplatine und speziell den Chip, der das eigentliche Sensorelement darstellt.

Es hat sich jedoch herausgestellt, dass ein solcher Elektronikchip sehr empfindlich auch auf sehr kleine mechanische Belastungen reagiert, und auch bei einem nur sehr leicht verformten Gehäuse des Sensors dadurch die Messergebnisse des Sensorelementes stark verfälscht werden.

### III. Darstellung der Erfindung

### a) Technische Aufgabe

Es ist daher die Aufgabe gemäß der Erfindung, einen Sensor zu schaffen, der auch beim Verschrauben auf einem unebenen Untergrund das darin befindliche Sensorelement, meist den eingesetzten Mikrochip, keiner mechanischen Belastung durch Verformung des Gehäuses aussetzt.

### b) Lösung der Aufgabe

Diese Aufgabe wird durch die Merkmale der Ansprüche **1** und **7** gelöst. Vorteilhafte Ausführungsformen ergeben sich aus den Unteransprüchen.

Vorab wird für die Zwecke der vorliegenden Anmeldung die ebene Unterseite des topfförmigen Gehäuses, die der offenen Seite gegenüberliegt, als Hauptebene definiert, und die darauf senkrecht stehende Richtung als axiale Richtung oder Lotrechte bezeichnet.

Ferner sind zwei grundsätzlich verschiedene Bauformen eines solchen Sensors hinsichtlich der Bauform des Gehäuses zu unterscheiden:

Bei der ersten Bauform sind die zum Festschrauben an der Umgebung vorgesehenen Befestigungsaugen einstückig zusammen mit dem Rest des Gehäuses, also insbesondere dem wannenförmigen Gehäuse-Korpus ausgebildet

Bei dieser Bauform wird die Aufgabe wird dadurch gelöst, dass die zum Verschrauben in den Befestigungsaugen des Sensors vorhandenen Durchgangsöffnungen vom Querschnitt so begrenzt sind, dass bei einer Befestigung mittels dort hindurch passender und festgezogener Schrauben keine so hohen Kräfte - auch bei unebenem Untergrund - in das Gehäuse eingebracht werden können, dass sich dieses verformen kann.

Zusätzlich wird das wannenförmige Gehäuse möglichst stabil und dennoch klein und kompakt ausgebildet, vorzugsweise, indem zumindest der wannenförmige Gehäuse-Korpus, vorzugsweise das gesamte Gehäuse (bis auf einen gegebenenfalls zusätzlich vorhandenen Deckel) aus Metall und nicht aus Kunststoff besteht, und allein dadurch schon wesentlich höhere Belastungen aufnehmen kann. Sowohl durch diese Materialwahl als auch die insbesondere einstückige Bauform des Gehäuses ist dieses besonders stabil.

In einer ersten Variante dieser ersten Bauform sind - quer zur Hauptebene des Gehäuses - die Befestigungsaugen gleich dick oder annähernd gleich dick wie der Wannen förmige Gehäuse-Korpus. Dadurch wird dafür Sorge getragen, dass sich die meist vom wannenförmigen Gehäuse abstehenden Befestigungsösen nicht gegenüber dem Rest des wannenförmigen Gehäuses verbiegen lassen, insbesondere indem die Dicke dieser Befestigungsösen mehr als **60** %, besser mehr als **80** %, besser mehr als **90** % und idealer Weise die gleiche Dicke besitzen wie die Höhe der umlaufenden Seitenwände des Gehäuses.

In einer zweiten Variante dieser ersten Bauform sind die Befestigungsaugen im Vergleich zum wannenförmigen Gehäuse-Korpus in Querrichtung zur Hauptebene relativ dünn ausgebildet, nämlich weniger als **50** %, besser weniger als **40** %, besser weniger als **30** %, besser weniger als **20** %, besser weniger als **10** % so dick wie der Gehäuse-Korpus.

Dadurch können sich beim Festschrauben zwar die Befestigungsaugen gegenüber dem wannenförmigen Gehäuse-Korpus verbiegen, aber eben nicht der Gehäuse-Korpus selbst.

Der Nachteil besteht darin, dass bei einem zu starken Verbiegen die Befestigungsaugen vom wannenförmigen Gehäuse-Korpus abbrechen können.

Bei einer zweiten Bauform umfasst das Gehäuse neben dem wannenförmige ein Gehäuse-Korpus ein separates, daran befestigtes Fixierungs-Teil, in dem die Durchgangsöffnungen zum festschrauben an einem Bauteil der Umgebung angeordnet sind, vorzugsweise außerhalb des in der Aufsicht betrachteten Grundrisses des wannenförmigen Gehäuse-Korpus.

Auch hier besteht der Effekt darin, dass sich beim Festschrauben zwar die Befestigungsaugen des separaten Fixierungsteiles gegenüber dem wannenförmigen Gehäuse-Korpus verbiegen können, aber eben nicht der Gehäuse-Korpus selbst.

Bei allen drei Bauformen bzw. Varianten kann durch im Wesentlichen die gleichen Maßnahmen ein weiterer Optimierungseffekt bewirkt werden:

Die umlaufenden Seitenwände werden vorzugsweise überall gleich hoch sein, sodass zusätzlich zur ebenen Bodenseite auch eine dazu parallele, ebene Frontseite des Gehäuses entsteht.

Vorzugsweise werden die Seitenwände dabei lotrecht zur Bodenfläche stehen, da dies eine Verformung der Seitenwände zusätzlich erschwert gegenüber schräg stehenden Seitenwänden, wie sie vor allem bei im Spritzgussverfahren aus Kunststoff hergestellten wannenförmigen Gehäusen unvermeidbar sind.

In der Aufsicht auf die Hauptebene von der offenen Frontseite her besitzt die Vertiefung, in die die Elektronikplatine eingelegt wird, eine unrunde Kontur und vorzugsweise besitzt auch die darin eingelegte Elektronikplatine zu mindestens teilweise die gleiche unrunde Kontur, und liegt an den Innenseiten der Seitenwände der Vertiefung am Umfang an wenigstens drei Punkten an und ist dadurch in Richtung der Hauptebene formschlüssig fixiert und gleichzeitig unverdrehbar in der Vertiefung aufgenommen.

Die Elektronikplatine nimmt also mindestens an zwei Stellen des Umfanges einen Abstand zu den Innenseiten der Seitenwände ein, sodass beim Vergießen der Elektronikplatine in der Vertiefung auf der einen Seite die Vergussmasse unter die Platine strömen kann und auf der anderen durch den anderen Abstand die dadurch verdrängte Luft entweichen kann.

Der breiteste Bereich der Vertiefung ist häufig zwischen den Durchgangsöffnungen für die Verschraubung angeordnet sein oder zumindest nahe an diesen Durchgangsöffnungen angeordnet sein, wobei vorzugsweise nur zwei einander gegenüberliegende Durchgangsöffnungen vorhanden sind.

Vorzugsweise besitzt die Vertiefung in der Aufsicht betrachtet eine schlüssellochförmige Kontur, bei der von diesem breitesten Bereich, dem Zentralbereich, ein Fortsatzbereich abragt. Bei dieser Gestaltung und einer analog gestalteten Elektronikplatine kann der Sensor-Chip und die Auswerteschaltung im breiteren Zentralbereich angeordnet werden, während der schmalere Fortsatzbereich vor allem der Zuführung eines Kabels zu der Elektronikplatine und dem Verlöten von dessen Adern an entsprechenden Lötpads oder anderen Befestigungsvorrichtungen für Adern an der Elektronikplatine dient.

Deshalb befindet sich vorzugsweise in der stirnseitigen Seitenwand dieses Fortsatzbereiches eine Durchgangsöffnung als Kabelöffnung zum Hindurchführen eines Kabels, vorzugsweise mit einem Innengewinde, in welches das Kabel mit seinem Mantel eingeschraubt wird und dadurch eine Zugentlastung des Kabels realisiert ist.

Dann reicht die Elektronikplatine nicht bis zum stirnseitigen Ende dieses Fortsatzbereiches, sondern endet im Abstand vorher, um in diesem Freiraum das Auffächern der Adern des Kabels zu ermöglichen.

Eine andere Möglichkeit besteht jedoch auch darin, die Elektronikplatine nicht eingelegt in die Vertiefung des wannenförmigen Sensorgehäuses zu vergießen, sondern vor dem Einlegen in das Gehäuse in einer Form zu Vergießen und Auszuhärten, sodass ein formbeständiger Vergusskörper entsteht, wobei jedoch die für Masse so ausgewählt wird, dass sie auch im vollständig aus gehärtetem Zustand noch begrenzt elastisch ist. Dieser Vergusskörper wird zwar ebenfalls - allerdings erst nach dem Aushärten - in die Vertiefung des Gehäuses eingelegt und passt dort hinein, jedoch liegt er an den Innenflächen der Seitenwände nur mit einigen wenigen, von dem Vergusskörper nach außen weisenden Vorsprüngen, an, was die Übertragung von Kräften vom Gehäuse auf den Vergusskörper sehr erschwert, da zunächst diese geringflächigen, elastischen Vorsprünge verformt würden.

Bei einem Verguss in dem Gehäuse liegt die Elektronikplatine auf dem Boden des Gehäuses auf, entweder mittels der an der Unterseite der Elektronikplatine angeordneten, von der Platine vorstehenden elektronischen Bauteilen oder auf speziellen, in dem Gehäuse vom Boden aufragenden Auflageflächen für die Elektronikplatine.

Die in dem Gehäuse befindliche - dort vor Ort vergossene oder in Form eines Vergusskörpers eingelegte - Elektronikplatine kann weiter geschützt werden, indem die offene Frontfläche des Gehäuses mittels einem aufgelegten, verklebten oder verschraubten Deckel dicht verschlossen werden kann, was bei weitestgehend aushärtendem Vergussmaterial und einem Verguss in dem wannenförmigen Gehäuse in aller Regel jedoch nicht notwendig ist. Stattdessen wird der fertige Sensor bei der Montage mit seiner offenen Frontfläche zu der Fläche, an der er befestigt werden soll, hinweisend angeordnet.

Die Wandstärke der Stirnwand des Fortsatzbereiches wird dabei deutlich größer gewählt, mindestens um den Faktor **1**,**5** größer, besser um den Faktor mindestens **2** größer, als die Wandstärke der angrenzenden, im Winkel zu dieser Stirnwand stehenden, Seitenwände. Dies dient vor allem dazu, um einem dort hindurch geführten Kabel eine ausreichende Dichtungslänge bieten zu können und/oder bei der Zugentlastung mittels Gewinde ein ausreichend langes Gewinde.

Die Seitenwände sollten an keiner Stelle eine minimale Wandstärke unterschreiten, und auch der in der Hauptebene gemessene Abstand zwischen der Vertiefung und den außerhalb der Vertiefung und nicht mit diesen in Verbindung stehenden Durchgangsöffnungen für das Verschrauben sollte größer sein als diese minimale Wandstärke.

Die minimale Wandstärke des Gehäuses oder des Gehäuse-Korpus beträgt vorzugsweise mindestens **10** %, besser mindestens **15** % der Höhe der Seitenwände, gemessen einschließlich der Dicke des sich an die Seitenfläche anschließenden Bodens.

Da die Belastung des Gehäuses durch das Verschrauben nicht nur durch die an einer einzelnen Verschraubungsstelle eingebrachten Kraft, sondern auch durch die Größe des Hebelarmes, mit dem diese Verschraubung auf das Gehäuse einwirkt abhängt, muss auch auf den Abstand der Durchgangsöffnungen ein Augenmerk gerichtet werden:

So sollte die Höhe der Seitenwände mindestens **12** %, besser mindestens **16** %, besser mindestens **20** % des Abstandes zwischen den beiden am weitesten voneinander entfernten Durchgangsöffnungen, gemessen von deren Mittelpunkt zu deren Mittelpunkt, betragen, damit die Höhe der Seitenwände analog mit dem Abstand der Verschraubungsöffnungen mitwächst.

Die Dicke des Bodens sollte maximal der minimalsten Wandstärke der Seitenwände entsprechen, da der Boden einem Verbiegen quer zur Hauptebene wenig Widerstand entgegensetzt.

Eine weitere Maßnahme besteht darin, den gegenseitigen Abstand der Durchgangsöffnungen für die Verschraubung so gering wie möglich zu wählen. So können diese Durchgangsöffnungen kostengünstig, da mit geringem Materialbedarf, beispielsweise im Übergangsbereich zwischen dem breitesten Bereich und dem Fortsatzbereich der Vertiefung, beispielsweise einer schlüssellochförmigen Vertiefung, außerhalb dieser Vertiefung angeordnet werden.

Vorzugsweise werden Durchgangsöffnungen einander gegenüberliegend im Bereich der geringsten Breite der Vertiefung angeordnet.

In aller Regel ist die Vertiefung als auch die Außenkontur des Gehäuses in der Aufsicht betrachtet seitensymmetrisch, also spiegelbildlich ausgebildet zur Symmetrieebene, die in der Richtung der längsten Erstreckung der Vertiefung und lotrecht zu Hauptebene verläuft.

### c) Ausführungsbeispiele

Ausführungsformen gemäß der Erfindung sind im Folgenden beispielhaft näher beschrieben. Es zeigen:
- Figur **1**a, b:: das Gehäuse einer ersten Bauform in der Aufsicht und im Längsschnitt,
- Figur c:: das Gehäuse der ersten Bauform im Querschnitt,
- Figur d:: das Gehäuse einer dritten Bauform im Querschnitt,
- Figur **2**a, b:: die Elektronikplatte in der Aufsicht und in der Seitenansicht,
- Figur **3**a, b:: das mit der Elektronikplatine bestückte und vergossene Gehäuse in der Aufsicht und in der Seitenansicht,
- Figur **4**:: eine zweite Bauform des Gehäuses in der Aufsicht,
- Figur **5**a, b:: das Gehäuse gemäß Figur 1a, b mit einem eingelegten Vergusskörper, der die Elektronikplatine enthält,
- Figur **6**:: den Sensor gemäß Figur **2**b mit weiteren Bauteilen.

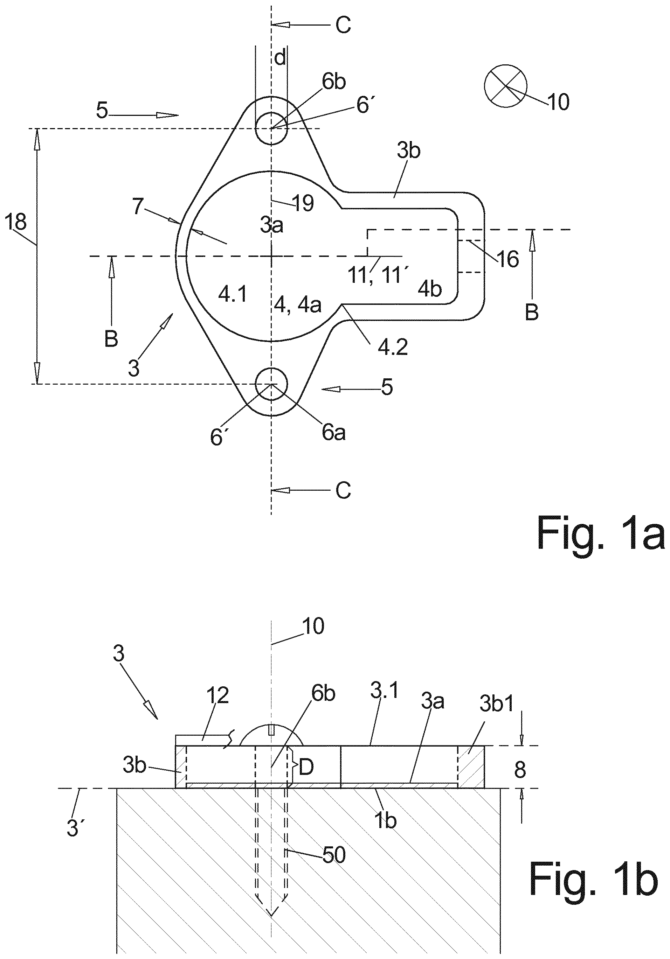

In den **Figuren 1a**, **b** ist das wannenförmige Gehäuse **3** einer ersten Bauform zunächst alleine dargestellt:

Es besteht aus einem Boden **3**a, von dessen Umfangskanten aus Seitenwände **3**b nach oben ragen, und eine zur Frontseite **3.1** hin offene Vertiefung **4** bilden, die somit begrenzt ist von einer Bodenfläche **4.1** und einer umlaufenden Seitenfläche **4.2**.

Damit kann das Gehäuse **3** sehr einfach aus einem plattenförmigen Rohmaterial hergestellt werden, indem daraus die Außenkontur des Gehäuses **3** ausgeschnitten wird und die Vertiefung **4** ausgefräst wird.

Das Gehäuse **3** besitzt somit eine ebene Frontseite **3.1**, in der sich die offene Seite der Vertiefung **4** befindet, und eine Bodenseite **3.2**, die parallel zueinander verlaufen, und letztere die Hauptebene **3'** des Gehäuses **3** definiert.

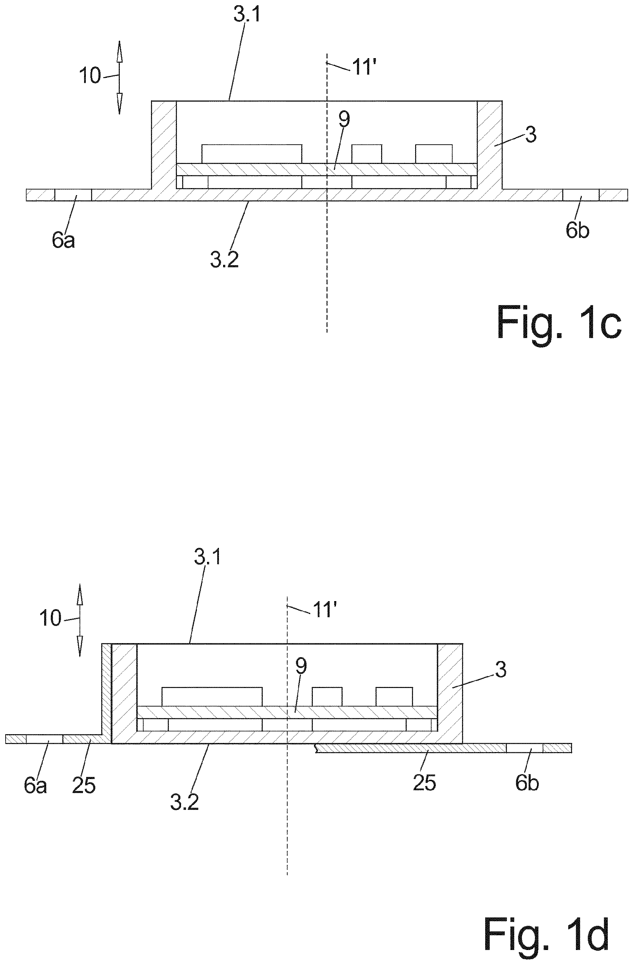

In Aufsicht auf den Boden **3**a des Gehäuses gemäß Figur **1**a, also der Lotrechten **10**, besitzt die Vertiefung **4** die Form eines Schlüsselloches, also mit einem breitesten Bereich **4**a in Form eines etwa über mehr als **270** Grad sich erstreckenden Kreissegmentes, und sich einen daran in eine Richtung anschließenden schmaleren Fortsatzbereich **4**b.

Diese Vertiefung **4** als auch das gesamte Gehäuse **3** ist zu einer Symmetrieebene **11**', die lotrecht auf der Hauptebene **3'** steht, seitensymmetrisch, also spiegelbildlich ausgebildet.

Beidseits des breitesten Bereiches **4**a der Vertiefung **4** sind die Seitenwände **3**b des Gehäuses stark verbreitert und bilden Befestigungsaugen **5**, durch die hindurch sich jeweils von der Frontseite **3.1** bis zur Rückseite **3.2** eine Durchgangsöffnung **6**a, **6**b erstreckt, die einen definierten Durchmesser d besitzt.

Die Befestigungsaugen **5** besitzen gemäß **Figur 1b** in der ersten Variante der ersten Bauform die gleiche Dicke in der Lotrechten wie die Wandhöhe **8** der überall gleich hohen Seitenwände **3**b, in der zweiten Variante der ersten Bauform gemäß **Figur 1c** eine sehr viel geringere Dicke, aber in beiden Fällen sind die Befestigungsaugen **5** einstückig zusammen mit dem topfförmigen Gehäuse-Korpus **3*** ausgebildet.

Diese Durchgangsöffnungen **6**a, b dienen zum Verschrauben des fertigen Sensors an einem Bauteil der Umgebung mit Hilfe einer sich durch diese Durchgangsöffnung **6**a, b jeweils hindurch erstreckenden Schraube **50**, wie in **Figur 1b** dargestellt. Die beiden Durchgangsöffnungen **6**a, b befinden sich in einem definierten Lochabstand **18** von Mittelpunkt **6'** zu Mittelpunkt **6'** der Durchgangsöffnungen **6**a,b, von denen bei dieser Bauform nur zwei vorhanden sind.

Wenn mehr als zwei Durchgangsöffnungen **6**a, b vorhanden sind, ist der für die Biegebelastung des verschraubten Gehäuses relevante Lochabstand **18** der größte Abstand zwischen zwei der mehr als zwei vorhandenen Durchgangsöffnungen **6**a, b.

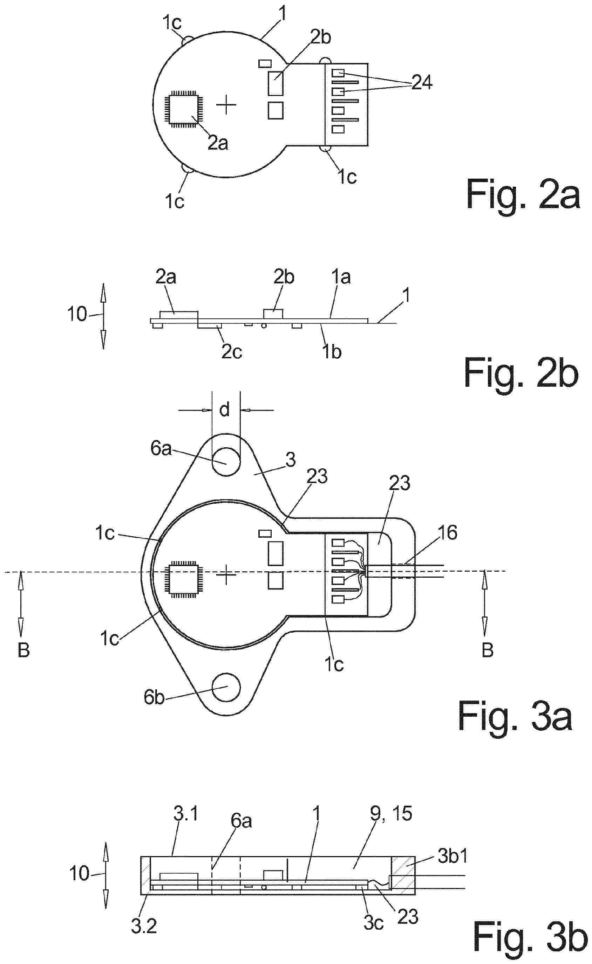

In der Seitenwand **3**b des Gehäuses, die parallel zum freien Ende des Fortsatzbereiches **4**b der Vertiefung **4** verläuft, befindet sich ferner eine Durchgangsöffnung **16** als Kabelöffnung, durch die hindurch ein Kabel **21** in das Gehäuse **3** eingeführt werden kann, um eine elektrische Verbindung zu der in dem Gehäuse **3 -** siehe die **Figuren 3a,b** **-** unterzubringenden Elektronikplatine **1** zu schaffen.

Diese Elektronikplatine **1** ist in den **Figuren 2a, b** zunächst separat dargestellt: Die Elektronikplatine **1** trägt in diesem Fall auf der Oberseite 1a als auch der Unterseite **1**b Bauelemente **2**a, b, c einer elektronischen Schaltung **2**, darunter auch das eigentliche Sensorelement, welches in der Regel auch als elektronisches Bauelement ausgebildet ist.

In der Aufsicht der **Figur 2a** betrachtet, besitzt die Elektronikplatine **1** etwa die gleiche Form wie die Vertiefung **4** in der Aufsicht betrachtet, also etwa die Form eines Schlüsselloches, jedoch mit kürzerem Fortsatzbereich **4**b.

Ferner besitzt die Elektronikplatine **1** in ihrer Hauptebene über die normale Umfangskontur nach außen ragende mindestens **3**, in diesem Fall **4**, Fortsätze **1**c, die so dimensioniert sind, dass diese im in das Gehäuse **3** eingelegten Zustand gemäß **Figur 3a** die Fortsätze **1**c genau an der Seitenfläche **4.2** der Vertiefung **4** anliegen.

Auf der Oberseite **1**a der Elektronikplatine **1** sind nahe des freien Endes des Fortsatz-Bereiches mehrere Löt-Pads **24** angeordnet, mit denen die auf der Elektronikplatine **1** vorliegende elektronische Schaltung mit den Adern eines durch die Kabelöffnung **16** herangeführten, in das Gehäuse **3** eingeführten, Kabels **21** verlötet werden kann, wie in **Figur 3a, b** eingezeichnet.

Hinsichtlich der Höhe, also der Vertikalen **10**, ist die Elektronikplatine **1** in der Vertiefung **4** häufig dadurch positioniert, dass die Platine **1** auf hierfür vorgesehenen Auflageflächen **3**c des Gehäuses **3** aufliegt, die sich entweder oberhalb des Niveaus der Bodenfläche **4.1** der Vertiefung **4** befinden und entweder von der Bodenfläche **4.1** aufragen oder/und von den Innenflächen **4.2** nach innen ragen, wie beispielsweise in **Figur 1d** dargestellt.

Die Elektronikplatine **1** kann jedoch alternativ auch mittels der an ihrer Unterseite **1**b befindlichen Bauelemente, zum Beispiel **2**c, auf dem Boden **3**a des Gehäuses aufliegen.

Nach dem Einlegen der Elektronikplatine **1** in das Gehäuse **3**, Einführen des Kabels **21** durch die stirnseitige Kabelöffnung **16** der Seitenwand **3**b in den Innenraum **4'** der Vertiefung **4,** des Gehäuses **3** und Verbinden, also meist Verlöten, seiner Adern **22** mit den Löt-Pads **24**, wird die Vertiefung **4** des Gehäuses **3** mit einer Vergussmasse **9** vergossen bis zur Oberkante der Seitenwände **3**b, sodass nach Aushärten der Vergussmasse **9** ein Vergusskörper **15** entsteht, der die Vertiefung **4** vollständig ausfüllt und mit dem Boden **3**a als auch mit den Innenseiten der Seitenwände **3**b verklebt ist. Denn aufgrund des zwischen Außenkante der Elektronikplatine **1** und dem Innenumfang der Vertiefung **4** vorhandenen Abstand **23** abseits der Fortsätze **1**c kann die Vergussmasse **9** auch unter die Elektronikplatine **1** einströmen.

Wie weiter oben dargelegt, kommt es bei der Gestaltung des Gehäuses **3** darauf an, dass abhängig von dem Lochabstand **18** der Durchgangsöffnungen **16**a, b, und deren Durchmesser d, welche den maximalen Durchmesser einer hindurchsteckbaren Schraube **50** vorgibt, das wannenförmige Gehäuse **3** hinsichtlich Materialwahl, Gestaltung und Dicke seiner Seitenwände **3**b und gegebenenfalls weiterer Faktoren, wie etwa der Dicke des Bodens **3**a, so dimensioniert wird, dass durch die maximal bei der Verschraubung des Gehäuses **3** oder des fertigen Sensors an einem Bauteil der Umgebung die auftretende Kraft und die vorliegenden Hebelarme nicht ausreichen, um das Gehäuse **3** zu verbiegen, insbesondere aus seiner Hauptebene **3'** heraus zu verbiegen.

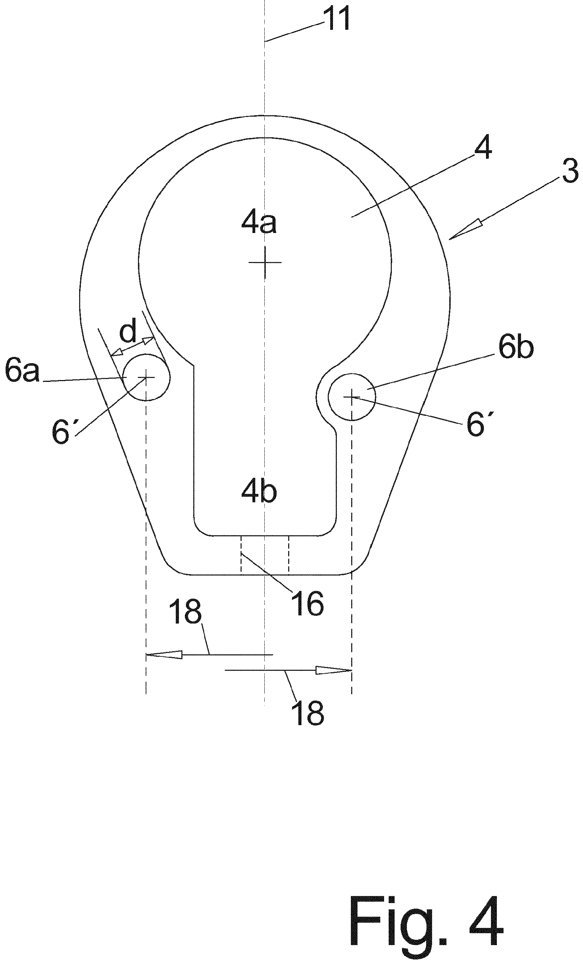

Die **Figur 4** zeigt zwei weitere zweite Bauformen des Gehäuses **3,** die dem Ziel dienen, den Lochabstand **18** zwischen den Durchgangsöffnungen **6**a, b und damit den maximal auftretenden Hebelarm zu reduzieren:

Bei der in der Aufsicht der **Figur 4** betrachteten Bauform in der linken Hälfte unterscheidet sich die Form des Gehäuses **3** und damit auch der Vertiefung **4** in ihrem Inneren dadurch, dass die Durchgangsöffnungen **6**a, b - von denen eben in der linken Hälfte nur die Durchgangsöffnung **6**a dargestellt ist - in Richtung der Längsmitte **11** nicht im Bereich der Vertiefung **4** liegt, sondern im Bereich der geringsten Breite, also im Fortsatzbereich **4**b oder im Übergangsbereich zwischen dem breitesten Bereich **4**a und **4**b, abseits der Vertiefung **4**.

Das Ziel besteht darin, die Durchgangsöffnung **6**a möglichst nahe an die Längsmitte **11** des Gehäuses **3** heran zu bringen und dadurch die auftretenden Hebellängen für die beim Verschrauben auftretenden Kräfte zu minimieren.

Noch besser realisiert wird dies bei der Lösung gemäß **Figur 4**, rechte Seite:

Dabei weist der Fortsatzbereich **4**b an einer Stelle noch eine Einbuchtung zur Längsmitte **11** hin auf, sodass die Vertiefung **4** innerhalb des Fortsatzbereiches **4**b nochmals eine Stelle mit geringster Breite aufweist, die geringer ist als der Fortsatzbereich **4**b am freien Ende, wo beispielsweise auf der Platine die Verlötung mit den Adern eines in das Gehäuse **3** hereingeführten Kabels **21** stattfinden muss.

Im Bereich dieser Einbuchtung nach innen könnte die in diesem Fall rechte dargestellte Durchgangsöffnung **6**b noch weiter in Richtung Längsmitte **11** verschoben werden, sodass zwischen der Durchgangsöffnung **6**b und der Vertiefung **4** nur noch die notwendige minimale Wandstärke vorliegt.

Wie unterhalb des Gehäuses **3** eingezeichnet, wird dadurch der Lochabstand **18** nochmals minimiert gegenüber der Lösung der linken Hälfte der **Figur 4**, und natürlich erst recht gegenüber der Bauform der **Figuren 1a****, b**.

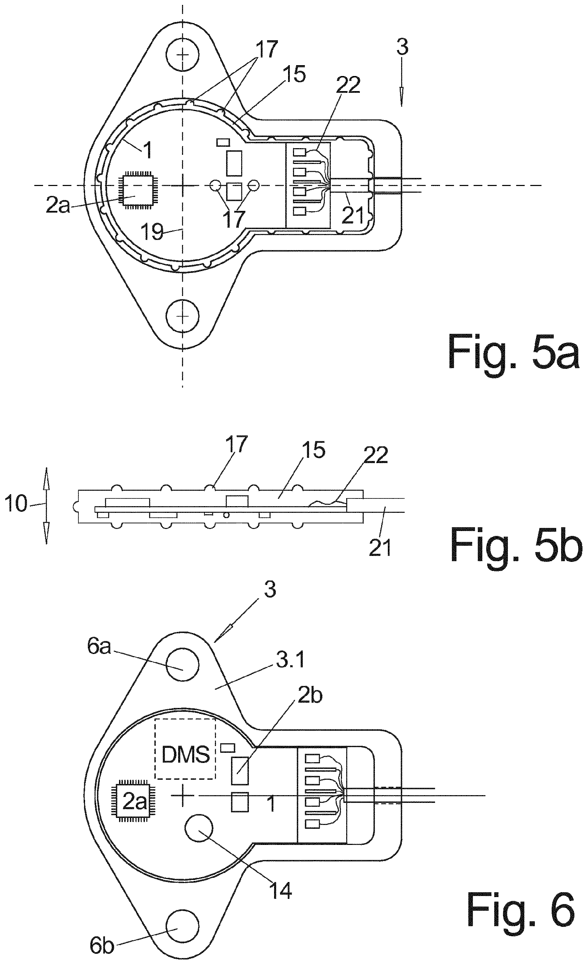

Die **Figuren 5a, b** zeigen eine Lösung, bei der die Elektronikplatine **1** und die darauf untergebrachte elektronische Schaltung **2** nicht in der Vertiefung **4** liegend vergossen wird, sondern außerhalb des Gehäuses **3** in einer nicht dargestellten Vergussform vergossen wird, natürlich mit bereits an die Elektronikplatine **1** und die dortige elektronische Schaltung **2** angeschlossenem Kabel **21**.

Dadurch wird ein Vergusskörper **15** geschaffen, der auf seiner Außenseite nach außen vorstehende Vorsprünge **17** aufweist, wobei der Vergusskörper **15** so dimensioniert ist, dass er nach dem Einbringen in das Gehäuse **3** nur noch mit diesen Vorsprüngen **17** am Innenumfang der Vertiefung **4** anliegt, deren offene Oberseite dann vorzugsweise mittels eines in **Figur 1b** angedeuteten Deckels **12** dicht verschlossen wird.

Die Vorsprünge **17** können sich in der Aufsicht gemäß **Figur 5a** betrachtet, an den Umfangsseiten des Vergusskörpers **15** befinden und/oder auf der Oberseite und/oder Unterseite des Vergusskörpers **15**, wie in der Seitenansicht der **Figur 5b** zu erkennen.

**Figur 6** zeigt in der Aufsicht auf das Gehäuse **3** gemäß **Figur 2b****,** also bei bereits eingelegter Elektronikplatine **1**, eine Ergänzung dahingehend, dass an dem Gehäuse **3 -** in diesem Fall unter der Elektronikplatine **1** auf dem Boden **3**a des Gehäuses **3 -** ein Dehnmessstreifen DMS angeordnet ist, der die Biegebelastung an dieser Stelle des Gehäuses misst und mittels elektrischer Verbindung mit der Schaltung **2** auf der Elektronikplatine **1** an diese weitergibt.

Mittels der elektronischen Schaltung wird ermittelt, ob sich die Biegebelastung des Gehäuses **3** und damit des gesamten Sensors unterhalb eines vorgegebenen, akzeptablen Schwellenwertes befindet und wenn nicht, wird mittels der elektronischen Schaltung ein Warnsignal an den Betreiber abgegeben.

Dieses Warnsignal kann beispielsweise bestehen im Aufleuchten einer auf der Oberseite der Elektronikplatine aufgebrachten Leuchtdiode **14**, die für den Betreiber bei Verwendung einer durchsichtigen Vergussmasse **9** sichtbar ist und eine zu starke mechanische Biegebelastung des Sensors anzeigt.

**Figur 1d** zeigt als dritte Bauform eine Lösung, bei der die Befestigungsaugen **5** gegenüber dem wannenförmigen Gehäuse-Korpus **3***separate, nachträglich daran befestigte, insbesondere verschraubte, oder verklebte, Fixierungs-Teile sind.

In der rechten Bildhälfte ist dargestellt, dass nur ein Fixierungs-Teil in Form einer Fixierungs-Platte **25** vorhanden ist, die unter der Unterseite des Gehäuse-Korpus **3*** durchgeht und mit diesem beispielsweise verschraubt ist.

In der linken Bildhälfte ist dargestellt, dass für jede Durchgangsöffnung **6**a, b eine eigene, in diesem Fall wegen Krieges, Fixierungs-Teil **25** vorhanden ist, welches mit einem Schenkel an der Außenseite des Gehäuse-Korpus **3*** anliegt und dessen anderer Schenkel, indem sich die Durchgangsöffnung **6**a, b befindet, hinsichtlich der Unterseite mit der Unterseite des Gehäuse-Korpus **3*** fluchtet.

In beiden Fällen kann durch die Kraft beim Verschrauben des einen oder der mehreren Fixierungs-Teile zwar dieses Fixierungs-Teil **25** verbogen werden, jedoch ist sowohl die Art der Befestigung am Gehäuse-Korpus **3** als auch die Ausbildung des Fixierungs-Teil des **25** so gewählt, dass dadurch dennoch kein Verformen des Innenraumes **4'** der Vertiefung **4** des Gehäuse-Korpus **3** eintritt.

Der Nachteil besteht jedoch darin, dass diese Verbindung zwischen dem Befestigungs-Teil **25** und dem Gehäuse-Korpus **3** ganz abreißen kann.

### BEZUGSZEICHENLISTE

- **1**: Elektronikplatine
- **1**a: Oberseite
- **1**b: Bodenseite
- **1**c: Fortsatz
- **2**: Schaltung
- **2**a, b: Bauelement
- **3**: Gehäuse
- **3.1**: Frontseite
- **3.2**: Bodenseite
- **3**': Hauptebene
- **3**a: Boden
- **3**b: Seitenwand
- **3**b**1**: Stirnwand
- **3**c: Auflagefläche
- **4**: Vertiefung
- **4**'^: Innenraum
- **4**.**1**: Bodenfläche
- **4**.**2**: Seitenfläche
- **4**a: breiteste Bereich
- **4**b: Fortsatz-Bereich
- **5**: Befestigungsauge
- **6**a, b: Durchgangs-Öffnung
- **6**': Mittelpunkt
- **7**: Wandstärke
- **8**: Wandhöhe
- **9**: Vergussmasse
- **10**: axiale Richtung, Lotrechte, Vertikale
- **11**: Längsmitte
- **11'**: Symmetrieebene
- **12**: Deckel
- **13**: Kabel
- **14**: Leuchtdiode
- **15**: Vergusskörper
- **16**: Kabelöffnung
- **17**: Vorsprung
- **18**: Loch-Abstand
- **19**: Verbindungslinie
- **20**: Lotrechte
- **21**: Kabel
- **22**: Ader
- **23**: Abstand
- **24**: Lötpads
- **25**: Fixierungsteil

- **50**: Schraube

- D: Dicke (von **5**)
- DMS: Dehnmessstreifen
- d: Durchmesser (von **6**a, b)
- F: Kraft

## Patentansprüche

1. Sensor mit
- einem wannenförmigen Gehäuse (**3**), welches abgesehen von einem eventuell vorhandenen Deckel (**12**) einstückig ausgebildet ist,
- einer Elektronikplatine (**1**) mit darauf angeordneter elektrischer Schaltung mit elektronischen Bauelementen (**2a,b**),
- mit einer zur Frontseite (**3.1**) hin offenen Vertiefung (**4**) zur Aufnahme der Elektronikplatine (**1**), gebildet durch eine Bodenfläche (**4.1**) und eine entlang der Ränder der Bodenfläche (**4.2**) umlaufende, von dieser aufragende Seitenfläche (**4.2**),
- wobei das Gehäuse (**3**) eine ebene, äußere Rückseite (**3.2**) aufweist, die die Hauptebene (**3**') des Gehäuses (**3**) definiert,
- wobei abseits der Vertiefung (**4**) sich je mindestens eine von wenigstens zwei Durchgangs-Öffnungen (**6**a, b) quer zur Hauptebene (**3**') durch je ein Befestigungsauge des Gehäuses (**3**) hindurch erstreckt, **dadurch gekennzeichnet, dass**
- der Durchmesser (d) der Durchgangs-Öffnungen (**6**a, b), nur maximal so groß ist, dass
- bei Auflegen des Gehäuses (**3**) mit der Rückseite (**3.2**) auf einer beliebig unebenen Auflagefläche sich der Innenraum (**4**') der Vertiefung (**4**) nicht verformt, wenn
- zentrisch zu den Durchgangs-Öffnungen (**6**a, b) jeweils eine Kraft (F) quer zur Hauptebene (**3**') an dem Gehäuses (**3**) aufgebracht wird, die grösser ist als die maximale Zugfestigkeit einer gerade noch durch die jeweilige Durchgangs-Öffnung (**6**a, b) durchsteckbaren Schraube (**50**).

2. Sensor nach Anspruch **1**,
**dadurch gekennzeichnet, dass**
die Frontseite (**3.1**) parallel zur ebenen Rückseite (**3.2**) verläuft und die umlaufenden Seitenwände (**3**b) überall die gleiche Wandhöhe (**8**) aufweisen.

3. Sensor nach einem der vorhergehenden Ansprüche,
**dadurch gekennzeichnet, dass**
sich der Innenraum (**4**') dabei nicht quer zu seiner Hauptebene (**3**') verformt und/oder
der Durchmesser (d) der Durchgangs-Öffnungen (**6**a, b) in Relation zum Material und den Abmessungen des Gehäuses (**3**), z.B. der Wandstärke (7) und der Wandhöhe (**8**), festgelegt ist.

4. Sensor nach einem der vorhergehenden Ansprüche,
**dadurch gekennzeichnet, dass**
die Dicke (D) der Befestigungsaugen (**5**) mehr als **60** %, besser mehr als **80** %, besser mehr als **90** % , insbesondere **100** %, der Höhe (**8**) der umlaufenden Seitenwände (**3**b) beträgt
und/oder
die Dicke (D) der Befestigungsaugen (**5**) geringer als **50** %, besser geringer als **40** %, besser geringer als **30** %, besser geringer als **20** %, besser geringer als **10** % der Höhe (**8**) der umlaufenden Seitenwände (**3**b) ist.

5. **Sensor** mit
- einem Gehäuse (**3**) mit
- einem wannenförmigen einstückigen Gehäuse-Korpus (**3**'),
- wenigstens einem daran befestigten Fixierungsteil zum Befestigen des Gehäuse-Korpus (**3**') an einem Bauteil der Umgebung,
- einem eventuell vorhandenen Deckel (**12**) zum Verschließen des Gehäuse-Korpus (**3**'),
- einer Elektronikplatine (**1**) mit darauf angeordneter elektronischer Schaltung mit elektronischen Bauteilen (**22**),
- mit einer zur Frontseite (**3.1**) hin offenen Vertiefung (**4**) im Gehäuse-Korpus (**3***), zur Aufnahme der Elektronikplatine (**1**), gebildet durch eine Bodenfläche (**4.1**) und eine entlang der Ränder der Bodenfläche (**4.2**) umlaufende, von dieser aufragende Seitenfläche (**4.2**),
- wobei das Gehäuse (**3**), insbesondere das darunter durchgehende Fixierungsteil, eine ebene, äußere Rückseite (**3.2**) aufweist, die die Hauptebene (**3**') des Gehäuses (**3**) definiert,
- wobei, insbesondere abseits der Vertiefung (**4**), sich wenigstens zwei Durchgangs-Öffnungen (**6**a, b) quer zur Hauptebene (**3**') durch das Fixierungsteil (**25**) hindurch erstrecken,
**dadurch gekennzeichnet, dass**
- der Durchmesser (d) der Durchgangs-Öffnungen (**6**a, b), nur maximal so groß ist, dass
- bei Auflegen des Gehäuses (**3**) mit seiner Rückseite (**3.2**) auf einer beliebig unebenen Auflagefläche sich der Innenraum (**4**') der Vertiefung (**4**) erst dann verformt, wenn
- zentrisch zu den Durchgangs-Öffnungen (**6**a, b) jeweils eine Kraft (F) quer zur Hauptebene (**3**') an dem Gehäuses (**3**) aufgebracht wird, die grösser ist als die maximale Zugfestigkeit einer gerade noch durch die jeweilige Durchgangs-Öffnung (**6**a, b) durchsteckbaren Schraube (**50**).

6. Sensor nach einem der vorhergehenden Ansprüche,
**dadurch gekennzeichnet, dass**
die umlaufenden Seitenwände (**3**b) auf der Rückseite (**3.2**) senkrecht stehen.

7. Sensor nach einem der vorhergehenden Ansprüche,
**dadurch gekennzeichnet, dass**
in der Aufsicht, der Lotrechten (**10**), auf die Hauptebene (**3**'), betrachtet die Vertiefung (**4**) eine unrunde Kontur aufweist, und insbesondere die Elektronikplatine (**1**) zumindest teilweise die gleiche unrunde Kontur aufweist und die Elektronikplatine (**1**) die Seitenwände (**3**b) der Vertiefung (**4**) im in diese Vertiefung (**4**) eingelegten Zustand an wenigstens drei Punkten berührt und/oder
der breiteste Bereich (**4**a) der Vertiefung (**4**) zwischen den Durchgangsöffnungen (**6**a, b) angeordnet ist und insbesondere von diesem breitesten Bereich (**4**a), dem Zentralbereich, sich in der Hauptebene (**3**') ein Fortsatz-Bereich (**4**b) mit geringerer Breite anschließt.

8. Sensor nach einem der vorhergehenden Ansprüche,
**dadurch gekennzeichnet, dass**
- die Vertiefung (**4**) in der Aufsicht betrachtet mitten-symmetrisch zu einer lotrecht zur Hauptebene (**3**') verlaufenden Symmetrieebene (**11'**) ist, in der auch die Richtung der größten Erstreckung der Vertiefung (**4**) in der Hauptebene (**3**'), liegt und
- insbesondere die Symmetrieebene (**11'**) angeordnet sind, und
- insbesondere In der Aufsicht betrachtet die Vertiefung (**4**) eine schlüssellochförmige Kontur besitzt.

9. Sensor nach einem der vorhergehenden Ansprüche,
**dadurch gekennzeichnet, dass**
- entweder die Elektronik-Platine (**1**) auf von der Bodenfläche (**4.1**) beabstandeten Auflageflächen (**3**c) des Gehäuses (**3**) aufsitzt
- oder die Elektronik-Platine (**1**) mit seinen an der Unterseite von der Elektronikplatine (**1**) vorstehenden elektronischen Bauteilen (**2**a, b) auf der Bodenfläche (**4.1**) aufliegt und
- insbesondere parallel zum Boden (**3**a) und/oder zur Frontseite (**3.1**) und/oder der Rückseite (**3.2**) des Gehäuses (**3**) in der Vertiefung (**4**) liegt.

10. Sensor nach einem der vorhergehenden Ansprüche,
**dadurch gekennzeichnet, dass**
- die Elektronik Platine (**1**) an mindestens zwei Umfangsstellen einen Abstand (**23**) zu der Seitenfläche (**4.2**) der Vertiefung (**4**) aufweist für das Hindurchströmen von Vergussmasse (**9**)
und/oder
- die offene Frontseite (**3.1**) des Gehäuses (**3**) von einem darauf verklebten und/oder am Gehäuse (**3**) verschraubten Deckel (**12**) verschlossen ist.

11. Sensor nach einem der vorhergehenden Ansprüche,
**dadurch gekennzeichnet, dass**
- die Elektronikplatine (**1**) in der Vertiefung (**4**) vollständig von wenigstens teilweise die Vertiefung (**4**) ausfüllender Vergussmasse (**9**) umschlossen ist und/oder
- die Elektronikplatine (**1**) in einem Vergusskörper (**15**) aus ausgehärteter Vergussmasse (**9**) aufgenommen ist, der an seiner Außenseite Vorsprünge (**17**), vorzugsweise kegelförmige oder leistenförmige, Vorsprünge (**17**), aufweist, mit denen er im eingelegten Zustand an der Seitenfläche (**4.2**) der Vertiefung (**4**) anliegt und insbesondere der Vergusskörper (**15**) mit möglichst wenigen Vorsprüngen (**17**) an dem Gehäuse (**3**) im eingelegten Zustand anliegt
und/oder
der Vergusskörper (**15**) in Richtung quer zur Hauptebene (**3**') abragende Vorsprünge (**17**) aufweist, die ausschließlich auf einer Lotrechten (**20**) zur Verbindungslinie (**19**') zwischen zwei Durchgangsöffnungen (**6**a, b) auf dem Vergusskörper (**15**) angeordnet sind.

12. Sensor nach einem der vorhergehenden Ansprüche,
**dadurch gekennzeichnet, dass**
in der Stirnwand (**3**b**1**) des Fortsatz-Bereiches (**4**b) eine Durchgangsöffnung (**16**), insbesondere mit Innengewinde, als Kabel-Auslass angeordnet ist und die Elektronik Platine (**1**) beanstandet zu dieser Stirnwand (**3**b**1**) im eingelegten Zustand endet und Befestigungsvorrichtungen, insbesondere Lötpads, zum Befestigen der Adern eines aus dem Gehäuse (**3**) herausführenden Kabels (**13**) aufweist.

13. Sensor nach einem der vorhergehenden Ansprüche,
**dadurch gekennzeichnet, dass**
die Wandstärke (**7**) der Stirnwand (**3**b**1**) des Fortsatz-Bereiches (**4**b) größer ist, insbesondere mindestens um den Faktor **1,5,** besser um den Faktor **2,0,** größer ist, als die der angrenzenden, im Winkel zu der Stirnwand (**3**b**1**) verlaufenden, Seitenwände (**3**b)
und/oder
die Seitenwände (**4**b) eine minimale Wandstärke (**7**) nicht unterschreiten, und auch der in der Hauptebene (**3**') gemessene Abstand (**18**) zwischen der Vertiefung (**4**) und den Durchgangsöffnungen (**6**a, b) größer ist als die minimale Wandstärke (**7**) und diese minimale Wandstärke (**7**) mindestens **10** %, besser mindestens **15** % der Höhe (**8**) der Seitenwände (**3**b) beträgt.

14. Sensor nach einem der vorhergehenden Ansprüche,
**dadurch gekennzeichnet, dass**
die Höhe (**8**) der Seitenwände (**3**b), mindestens **12** %, besser mindestens **16** %, besser mindestens **20** % des Loch-Abstandes (**18**) zwischen den beiden am weitesten voneinander entfernten Durchgangsöffnungen (**6**a, b), gemessen entlang der Verbindungslinie (**19**) vom Mittelpunkt (**6**') zum Mittelpunkt (**6**'), beträgt
und/oder
die Dicke des Bodens (**3**a) des Gehäuses (**3**) maximal der minimalsten Wandstärke (**7**) der Seitenwände (**3**b) des Gehäuses (**3**) entspricht.

15. Sensor nach einem der vorhergehenden Ansprüche,
**dadurch gekennzeichnet, dass**
- an dem Gehäuse (**3**), insbesondere dessen Boden (**3**a), auf der Außenseite und/oder Innenseite, ein Dehnmess-Streifen (DMS) angeordnet ist, der mit der elektronische Schaltung (**2**) auf der Elektronikplatine (**1**) verbunden ist, und
- insbesondere auf der der Frontseite (**1**a) zuweisenden Seite der Elektronikplatine (**1**) eine Leuchtdiode (**14**) oder mehrere Leuchtdioden (**14**) angeordnet sind, die durch Leuchten oder Nicht-Leuchten anzeigen, ob die von dem Dehnmess-Streifen (DMS) gemessene mechanische Spannung des Gehäuses (**3**) innerhalb oder außerhalb eines zulässigen Bereiches liegt.

16. Sensor nach einem der vorhergehenden Ansprüche,
**dadurch gekennzeichnet, dass**
drei Leuchtdioden (**14**) mit den Farben Grün, Gelb und Rot vorhanden sind und die Vergussmasse (**9**) wenigstens teilweise durchsichtig ist.

17. Sensor nach einem der vorhergehenden Ansprüche,
**dadurch gekennzeichnet, dass**
die Durchgangsöffnungen (**6**a, b) einander gegenüberliegend abseits der Vertiefung (**4**) in so gering wie möglichem Abstand (**18**) angeordnet sind und insbesondere im Bereich des Überganges zwischen dem breitesten Bereich (**4**a) und dem Fortsatzbereich (**4**b) der Vertiefung (**4**) diese eine Einschnürung, zur Längsmitte (**11**) hin aufweist, und die Durchgangsbohrungen (**6**a, b) im axialen Bereich der Einschnürung so nah wie möglich an der Vertiefung (**4**) angeordnet sind
und/oder
die Durchgangsöffnungen (**6**a, b) im Bereich der geringsten Breite der Vertiefung (**4**) außerhalb und ohne Verbindung zu der Vertiefung (**4**) und einander gegenüberliegend bezüglich der Vertiefung (**4**) angeordnet sind.
